# EUROPÄISCHE PATENTSCHRIFT

(11) **EP 1 459 354 B1**
(45) Veröffentlichungstag und Bekanntmachung des Hinweises auf die Patenterteilung: **14.06.2006**
(21) Anmeldenummer: 02781125.6
(22) Anmeldetag: 04.10.2002
(51) Int. Cl.: H01L 21/00, H01L 21/68

(54) **HALTEVORRICHTUNG UND VERFAHREN ZUR WÄRMEZUFUHR ODER WÄRMEABFUHR VON EINEM SUBSTRAT**
RETAINING DEVICE, ESPECIALLY FOR FIXING A SEMICONDUCTOR WAFER IN A PLASMA ETCHING DEVICE, AND METHOD FOR SUPPLYING HEAT TO OR DISCHARGING HEAT FROM A SUBSTRATE
DISPOSITIF DE RETENUE, NOTAMMENT CONCU POUR FIXER UNE PLAQUETTE A SEMI-CONDUCTEURS DANS UN DISPOSITIF DE GRAVURE AU PLASMA, ET PROCEDE POUR APPORTER DE LA CHALEUR A UN SUBSTRAT OU POUR EVACUER DE LA CHALEUR D'UN SUBSTRAT

(30) Priorität: 16.11.2001 DE 10156407
(43) Veröffentlichungstag der Anmeldung: 22.09.2004
(60) Teilanmeldung: 06101547.5
(73) Patentinhaber: ROBERT BOSCH GMBH, 70442 Stuttgart (DE)
(72) Erfinder: BREITSCHWERDT, Klaus, 70794 Filderstadt (DE); LAERMER, Franz, 71263 Weil der Stadt (DE); SCHILP, Andrea, 70563 Stuttgart (DE)
(86) Internationale Anmeldenummer: PCT/DE2002/003767
(87) Internationale Veröffentlichungsnummer: WO 2003/046953

(56) Entgegenhaltungen:
- EP-A- 0 511 928
- EP-A- 0 669 644
- EP-A- 0 755 066
- EP-A- 0 777 262
- EP-A- 1 114 805
- WO-A-00/70657
- US-A- 5 073 716
- US-A- 5 885 423
- US-A- 5 904 776
- US-A- 5 986 875
- US-A1- 2001 005 595
- PATENT ABSTRACTS OF JAPAN vol. 1999, no. 14, 22. Dezember 1999 (1999-12-22) -& JP 11 265879 A (MATSUSHITA ELECTRIC IND CO LTD), 28. September 1999 (1999-09-28)
- PATENT ABSTRACTS OF JAPAN vol. 2000, no. 04, 31. August 2000 (2000-08-31) -& JP 2000 031253 A (KOMATSU LTD), 28. Januar 2000 (2000-01-28)
- PATENT ABSTRACTS OF JAPAN vol. 1995, no. 03, 28. April 1995 (1995-04-28) -& JP 06 349938 A (TOKYO ELECTRON LTD), 22. Dezember 1994 (1994-12-22)
- PATENT ABSTRACTS OF JAPAN vol. 1996, no. 01, 31. Januar 1996 (1996-01-31) -& JP 07 235588 A (HITACHI LTD), 5. September 1995 (1995-09-05)

## Beschreibung

Die Erfindung betrifft Haltevorrichtungen, insbesondere zum Fixieren eines Halbleiterwafers in einer Plasmaätzvorrichtung, sowie ein Verfahren zur Zufuhr oder Abfuhr von Wärme von der Rückseite eines mit einer dieser Haltevorrichtungen in einer Vakuumkammer gehaltenen Substrates, nach der Gattung der unabhängigen Ansprüche.

### Stand der Technik

Beim anisotropen Hochratenätzen von Siliziumsubstraten, beispielsweise nach Art der DE 42 41 045 C1, ist eine Kühlung des Substrates von dessen Rückseite aus erforderlich, da aus dem Plasma durch die Einwirkung von Strahlen, Elektronen und Ionen sowie auch durch eine entstehende Reaktionswärme auf der Waferoberfläche in erheblichem Ausmaß Wärme in dieses eingetragen wird. Wird diese Wärme nicht kontrolliert abgeführt, überhitzt das Substrat und das Ätzergebnis verschlechtert sich erheblich.

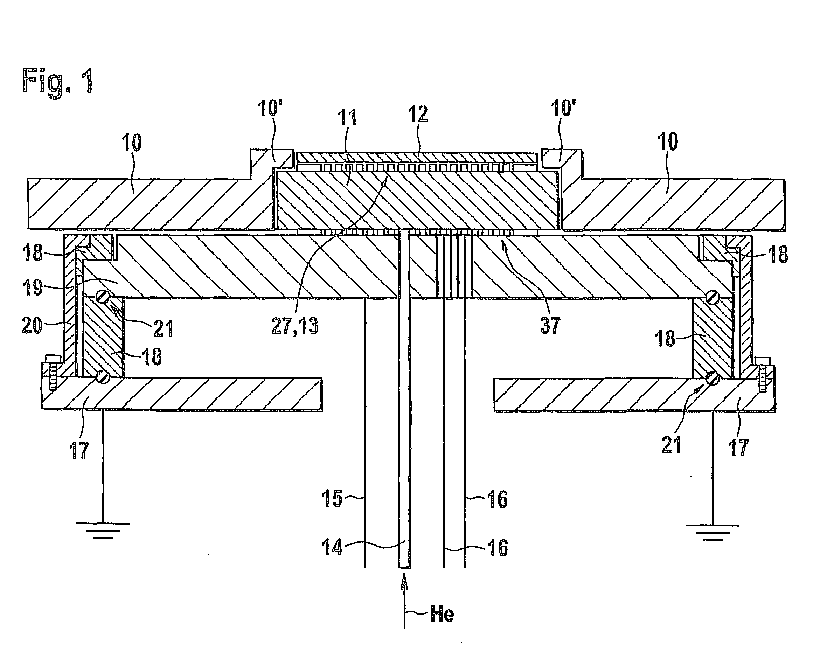

Aus US 6,267,839 B1, US 5,671,116, EP 840 434 A2 oder JP-11330056 A sind sogenannte elektrostatische "Chucks" bekannt, d.h. Haltevorrichtungen, mit denen ein Halbleiterwafer, insbesondere ein Siliziumwafer, beispielsweise in einer Plasmaätzvorrichtung auf einer Substratelektrode elektrostatisch fixierbar ist. Eine weitere, aus dem Stand der Technik bekannte Haltevorrichtung in Form eines elektrostatischen "Chucks" zeigt Figur 1. Diese Ausführungsform ist derzeit in vielen Plasmaätzanlagen anzutreffen und typisch für den Stand der Technik.

Im Einzelnen ist dabei vorgesehen, dass die mit einer beispielsweise hochfrequenten Spannung beaufschlagte Substratelektrode vermöge Keramikisolatoren und einer geeigneten Klemmvorrichtung auf eine geerdete Bodenplatte geklemmt wird, wobei O-Ringe die Vakuumdichtigkeit sicherstellen, so dass das zu ätzende Substrat einem Vakuum ausgesetzt werden kann. Weiter ist vorgesehen, dass die Substratelektrode intern von einem Kältemittel, beispielsweise deionisiertem Wasser, Methanol oder anderen Alkoholen, Fluorcarbonen oder Siliconen durchströmt wird. Auf der Substratelektrode selbst findet sich dann der "Chuck" für die elektrostatische Klemmung des darauf liegenden Wafers oder Substrates, der über übliche Hochspannungsdurchführungen mit Hochspannung versorgt wird, um die gewünschte Klemmkraft auf den darauf angeordneten Wafer auszuüben. Schließlich ist im Stand der Technik gemäß Figur 1 vorgesehen, dass die von dem Substrat nicht bedeckte Oberfläche des "Chucks" und der umgebenden Substratelekrodenoberfläche durch eine auf die Substratelektrode aufgelegte Keramikplatte abgedeckt wird, um eine Einwirkung des darüber befindlichen bzw. erzeugten Plasmas auf die Metallflächen der Substratelektrode, was zu einem schädlichen Absputtern von Metall und einem unerwünschten Stromfluss ins Plasma führen könnte, auszuschließen.

Den Wärmefluss von der Unterseite des aufgelegten Wafers zu dem elektrostatischen "Chuck" bzw. der Substratelektrode gewährleistet schließlich ein Heliumpolster, d.h. es sind geeignet geformte Zwischenräume zwischen Waferunterseite und "Chuck" und zwischen "Chuck" und Substratelektrodenoberfläche vorgesehen, die mit Helium bei einem Druck von einigen mbar bis maximal etwa 20 mbar gefüllt sind.

Alternativ zur elektrostatischen Klemmung bzw. Fixierung eines Wafers sind im Stand der Technik auch mechanische Klemmvorrichtungen bekannt, die den Wafer auf die Substratelektrode drücken und die Beaufschlagung der Rückseite des Wafers mit Helium als Konvektionsmedium gestatten. Die mechanische Klemmung weist jedoch erhebliche Nachteile auf, und wird zunehmend von elektrostatischen "Chucks", die vor allem eine günstige flächige Waferklemmung gewährleisten, verdrängt.

Aus EP0669644 ist eine elektrostatische Haltevorrichtung bekannt.

Aus JP 11265879 ist eine Haltevorrichtung bekannt, bei den der wafer mittels eines klemmrings befesfigt wird.

### Vorteile der Erfindung

Die erfindungsgemäßen Haltevorrichtungen und das erfindungsgemäße Verfahren zur Zufuhr oder Abfuhr von Wärme von der Rückseite eines in einer Vakuumkammer gehaltenen Substrates haben gegenüber dem Stand der Technik den Vorteil, dass damit eine deutlich verbesserte thermische Ankopplung des Wafers an den darunter befindlichen "Chuck" bzw. die Substratelektrode erreicht wird, und dass die Zufuhr bzw. Abfuhr von Wärme von der Rückseite des Substrates wesentlich zuverlässiger, gleichmäßiger und effektiver erfolgt.

Insbesondere hat sich herausgestellt, dass gerade in Verbindung mit üblichen Plasmahochratenätzverfahren die Umgebung des Wafers und vor allem die Temperatur der gemäß Figur 1 aufgelegten keramischen Platte, die nicht direkt in Verbindung mit dem geätzten Wafer steht, eine wesentliche Rolle hinsichtlich des Prozessergebnisses spielt.

So führt die bisher eingesetzte, lediglich aufgelegte keramische Platte zu erheblichen Inhomogenitäten der Ätzung von der Mitte des Wafers zum Waferrand hin und insbesondere zu einer Ätzratenüberhöhung im Waferrandbereich, was einer unzureichenden und/oder ungleichmäßigen Wärmeabfuhr von der keramischen Platte, die aufgeheizt schädliche Effekte in ihrer Umgebung, d.h. auch im Waferrandbereich, entwickelt, an die Substratelektrode zugeschrieben wird. Diese Nachteile werden durch die erfindungsgemäßen Haltevorrichtungen überwunden.

Weiterhin ist bei der in Figur 1 skizzierten Konstruktion nachteilig, dass Helium als Konvektionsmedium nur eine vergleichsweise beschränkte Wärmeableitung leisten kann, die nur durch einen größeren Gasdruck steigerbar ist. Hier setzen jedoch die elektrostatischen Haltekräfte üblicher elektrostatischer "Chucks" eine Obergrenze von 10 mbar bis 20 mbar. Auch eine alternative mechanische Waferklemmung im Bereich des Waferrandes bietet keine befriedigende Lösung, da Drücke von mehr als 20 mbar dazu führen können, dass die Wafer unter der dadurch auf sie ausgeübten Kraft brechen. Diese Nachteile werden vor allem durch das in einer erfindungsgemäßen Ausführungsform eingesetzte elektrisch isolierende Ferroelektrikum oder Piezoelektrikum überwunden, mit denen eine deutliche höhere elektrostatische Klemmkraft auf den Wafer ausübbar ist, und die so eine Erhöhung des Druckes des Konvektionsmediums, insbesondere Helium, auf mehr als 20 mbar erlauben.

Im Übrigen sind die mit bisher üblichen elektrostatischen "Chucks" erreichbaren elektrostatischen Haltekräfte auch deshalb ungenügend, weil sie durch die Durchschlagsfestigkeit der eingesetzten Dielektrika im "Chuck" limitiert werden. Insofern sind die Klemmspannungen bisher auf den Bereich zwischen 1000 V und 2000 V beschränkt. Bei höheren Spannungen nimmt sowohl das Durchschlagsrisiko erheblich zu als auch die Lebensdauer der eingesetzten Dielektrika ab. Mit dem Durchschlagsrisiko einher gehen zudem erhebliche EMV-Risiken (EMV = elektromagnetische Verträglichkeit), über die Schäden in der Elektronik der Plasmaätzanlage drohen. Auch diese Problematik wird durch die erfindungsgemäße Haltevorrichtung deutlich entschärft.

Im Übrigen ist vorteilhaft, dass die verschiedenen erfindungsgemäßen Haltevorrichtungen, die einerseits auf eine verbesserte und vergleichmäßigtere Wärmeabfuhr von der Rückseite des Substrates und eine gleichmäßigere Wärmeverteilung in der Umgebung des geätzten Substrates abzielen, und die andererseits einer Erhöhung der elektrostatischen Klemmkräfte und einer vereinfachten Fixierung beziehungsweise Lösung des Wafers von der Haltevorrichtung dienen, beliebig miteinander kombinierbar sind.

Vorteilhafte Weiterbildungen der Erfindung ergeben sich aus den in den Unteransprüchen genannten Maßnahmen.

### Zeichnung

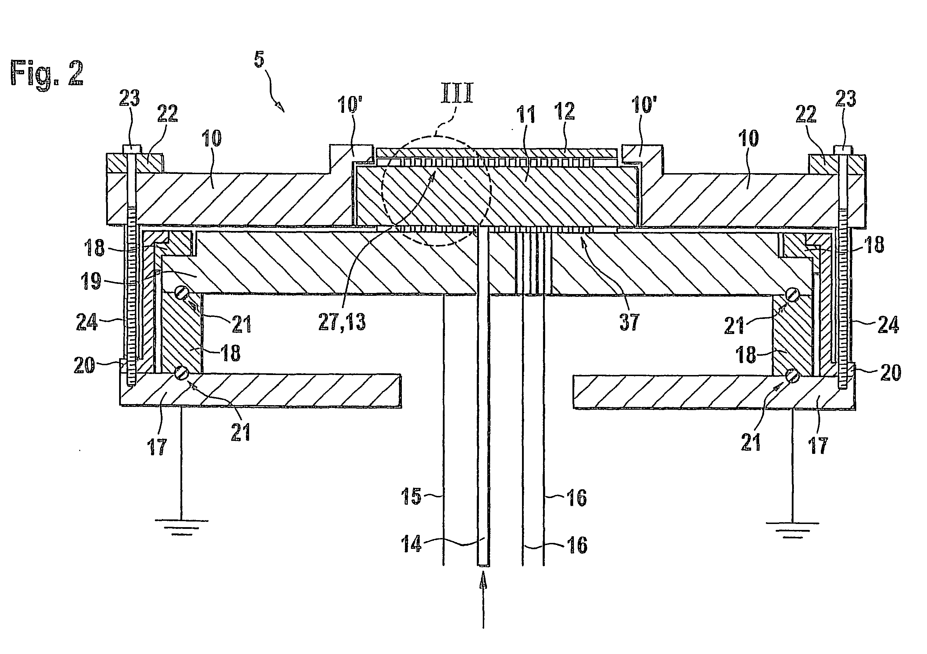

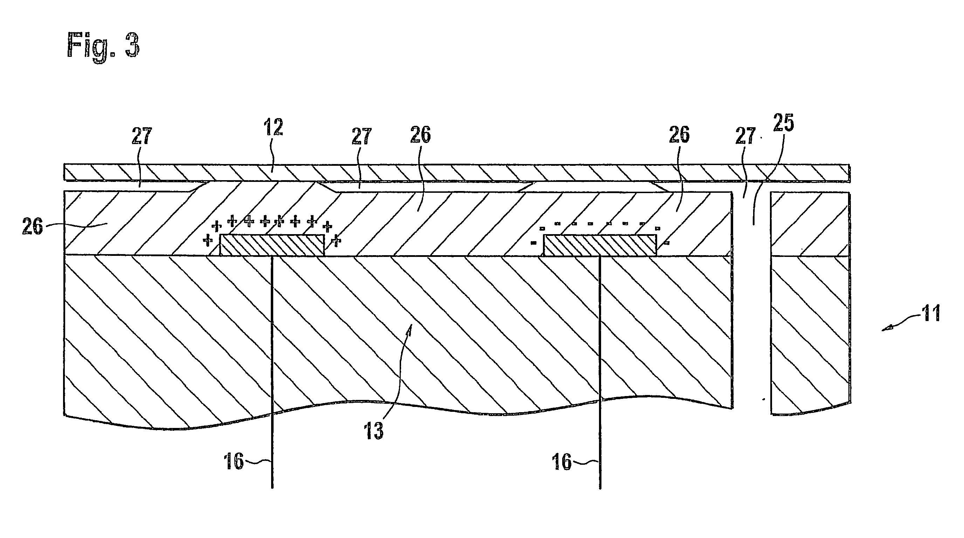

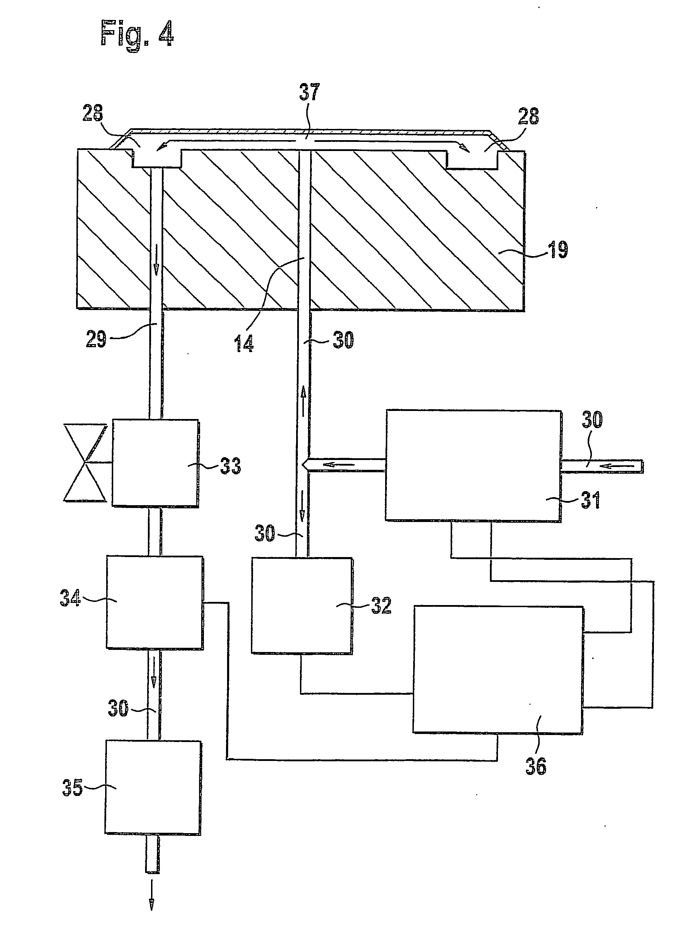

Die Erfindung wird anhand der Zeichnungen und in der nachfolgenden Beschreibung näher erläutert. Es zeigt Figur 1 eine aus dem Stand der Technik bekannte elektrostatische Haltevorrichtung, Figur 2 ein erstes Ausführungsbeispiel der Erfindung mit einer gegenüber Figur 1 modifizierten elektrostatischen Haltevorrichtung, Figur 3 ein zweites Ausführungsbeispiel der Erfindung, wobei lediglich der in Figur 2 gestrichelt gekennzeichnete Bereich dargestellt ist, und Figur 4 ein drittes Ausführungsbeispiel der Erfindung, wobei die Kühlung der Rückseite eines in der Vakuumkammer gehaltenen Substrates mit Hilfe eines flüssigen Konvektionsmediums dargestellt ist.

### Ausführungsbeispiele

Die Figur 1 erläutert zunächst einen aus dem Stand der Technik bekannten elektrostatischen "Chuck", das heißt eine elektrostatische Haltevorrichtung für ein Substrat 12, beispielsweise einen üblichen Siliziumwafer. Unter dem Substrat 12 befindet sich ein dieses fixierendes Halteelement 11, beispielsweise ein in Form eines Haltetellers ausgeführter elektrostatischer "Chuck". Das Halteelement 11 ist weiter auf eine metallische Substratelektrode 19 aufgelegt, die über vorzugsweise keramische Isolatoren 18 mit einem Grundkörper oder Tragkörper 17 verbunden ist, der ebenfalls aus einem Metall besteht. Zur Gewährleistung der Vakuumdichtigkeit sind zwischen den Isolatoren 18 und der Substratelektrode 19 bzw. zwischen den Isolatoren 18 und dem Grundkörper 17 Dichtungen 21, beispielsweise O-Ringe aus Gummi, vorgesehen.

In Figur 1 ist weiter dargestellt, dass der Grundkörper 17 über einen metallischen Halter 20 mit der Substratelektrode 19 verbunden ist, wobei zwischen dem Halter 20 und der Substratelektrode 19 ebenfalls vorzugsweise keramische Isolatoren 18 vorgesehen sind, so dass der Grundkörper 17 insgesamt gegenüber der Substratelektrode 19 elektrisch isoliert ist. Darüber hinaus ist auf die Substratelektrode 19 eine keramische Platte als Lastkörper 10 aufgelegt, der so geformt ist, dass er in seiner Mitte eine beispielsweise kreisförmige Öffnung aufweist, die größer als das Substrat 12 ist, und der weiter mittels eines überstehenden Teils 10' oder einer "Nase" so ausgebildet ist, dass er das Halteelement 11 durch sein Gewicht auf die Substratelektrode 19 drückt. Auf diese Weise belastet der Lastkörper 10 das Halteelement 11 ohne das Substrat 12 abzudecken, so dass dieses von oben beispielsweise einer Plasmaätzung zugänglich ist.

Der Grundkörper 17 gemäß Figur 1 ist geerdet, während die Substratelektrode 19 in bekannter Weise mit einer Hochspannungszuführung 15 verbunden ist, über die sie mit einer Hochfrequenzleistung beaufschlagbar ist. Daneben weist die Substratelektrode 19 dieser gegenüber isolierte Durchführungen, beispielsweise Keramikdurchführungen, auf, so dass über Klemmspannungszuführungen 16 eine Beaufschlagung des Halteelementes 11 mit einer elektrischen Gleichspannung, beispielsweise einer elektrischen Spannung von 1000 V bis 2000 V, möglich ist. Die Substratelektrode 19 ist dabei gegenüber dieser Spannung elektrisch isoliert, so dass diese lediglich am Halteelement 11 anliegt und dort über eine elektrostatische Klemmung bzw. eine durch die über die Klemmspannungszuführungen 16 induzierte elektrostatische Kraft eine Klemmung oder Fixierung des Substrats 12 auf dem Halteelement 11 bewirkt. Gleichzeitig wird das Halteelement 11 auch durch eine ebensolche elektrostatische Kraft von seiner Unterseite ausgehend gegen die Substratelektrode 19 geklemmt.

Schließlich ist in Figur 1 vorgesehen, dass über eine Zuführung 14 der der Substratelektrode 19 zugewandten Seite des Halteelements 11 als Konvektionsmedium 30 gasförmiges Helium zuführbar ist, das über in dem Halteelement 11 vorgesehene Kanäle 25 auch in den Bereich zwischen dem Halteelement 11 und dem Substrat 12 vordringen kann. Das Konvektionsmedium 30 dient der Wärmeabfuhr aus dem Bereich zwischen Substratelektrode 19 und Halteelement 11 und aus dem Bereich zwischen dem Halteelement 11 und der Rückseite des Substrates 12. Entsprechend weist der Halteteller 11 auf seiner Oberseite und Unterseite bevorzugt in bekannter Weise eine entsprechend strukturierte Haltefläche 13 auf.

Die Figur 2 zeigt ein erstes Ausführungsbeispiel der Erfindung für eine Haltevorrichtung 5, die ähnlich der Haltevorrichtung gemäß Figur 1 aufgebaut ist, bei der jedoch vor allem das thermische "Floaten" des in Figur 1 vorgesehenen keramischen Lastkörpers um das Substrat 12 herum beseitigt wurde.

Im Einzelnen ist gemäß Figur 2 vorgesehen, dass mittels eines Aluminiumringes oder eines Eloxalringes oder allgemeiner einer bevorzugt in Form eines Klemmringes ausgeführten Klemmeinrichtung 22 der Lastkörper 10 mit dem geerdeten Grundkörper 17 fest verbunden und so gegen die Oberfläche der Substratelektrode 19 gepresst wird. Dabei ist die Klemmeinrichtung 22 und die Verbindung der Klemmeinrichtung 22 mit dem Grundkörper 17 über ein Befestigungselement 23 und ein Verbindungselement 24 so ausgeführt, dass der Lastkörper 10, der ohnehin aus einem Isolator wie Keramik oder Quarzglas besteht, und der Grundkörper 17 gegenüber der Substratelektrode 19 elektrisch isoliert sind. Das Befestigungselement 23 ist im erläuterten Beispiel eine Schraube, während das Verbindungselement 24 beispielsweise eine Hülse, ein Stab oder ebenfalls eine Schraube ist. Die Verwendung eines Klemmringes als Klemmeinrichtung 22 übt vorteilhaft eine sehr gleichmäßige Klemmkraft auf den Lastkörper 10 aus, so dass die Gefahr eine Abscherens oder Spaltens ausgeschlossen wird.

Insgesamt wird durch die Haltevorrichtung 5 gemäß Figur 2 eine verbesserte thermische Ankoppelung des Lastkörpers 10 an die Temperatur der Substratelektrode 19 erreicht, was zu einer signifikanten Verbesserung der Eigenschaften eines Hochratenplasmaätzprozesses, beispielsweise nach Art der DE 42 41 045 C1, vor allem im Randbereich des Substrates 12 führt. Daneben wird darüber auch ein unerwünschter Prozessdrift zwischen einem heißen und einem kalten Anlagezustand vermieden oder reduziert, der wesentlich von einem Aufheizen des Lastkörpers 10, der beispielsweise weiterhin als keramische Platte ausgeführt ist, unmittelbar um das Substrat 12 herum resultiert.

In einer bevorzugten Ausführungsform des erläuterten Ausführungsbeispiels ist zwischen dem Lastkörper 10 und der Oberfläche der Substratelektrode 19 zusätzlich eine Oberflächenunebenheiten ausgleichende und einen gleichmäßigen, möglichst guten Wärmeabfluss gewährleistende Schicht, vorzugsweise eine Silikonfettschicht oder eine Fettschicht aus einem perfluorierten Fett wie Krytox®-Fett oder Fomblin®⁻Fett, vorgesehen.

Generell ist wichtig, dass die gewünschte Klemmung über den geerdeten Grundkörper 17 und nicht über die mit einer hochfrequenten Leistung beaufschlagte Substratelektrode 19 selbst erfolgt, da in diesem Fall die Hochfrequenz auf die Klemmeinrichtung 22 einwirkte, was negative Auswirkungen auf den Plasmaätzprozess hätte und auch zu Absputtereffekten führte. Insofern ist es im Fall des erfindungsgemäßen Ausführungsbeispiels gemäß Figur 2 auch aus elektrischen Gründen vorteilhaft, dass der über den Grundkörper 17 geerdete Klemmring 22 um das Substrat 12 herum verläuft und elektrisch leitend ist.

Die Figur 3 zeigt den in Figur 2 gestrichelt gekennzeichneten Ausschnitt aus Figur 2, wobei zunächst erkennbar ist, dass das Halteelement 11 gemäß Figur 2 bevorzugt eine Mehrzahl, beispielsweise 6 bis 8, von dieses durchquerenden Kanälen 25 aufweist, die von der der Substratelektrode 19 zugewandten Seite des Halteelementes 11 bis zu der dem Substrat 12 zugewandten Seite des Halteelementes 11 führen. Über die Kanäle 25 kann ein mit der Zuführung 14 zugeführtes Konvektionsmedium in den Bereich unterhalb des Substrates 12 gelangen. Weiter weist das Halteelement 11 auf seiner dem Substrat 12 zugewandten Seite eine in an sich bekannter Weise strukturierte Haltefläche 13 auf, die in dem Ausführungsbeispiel gemäß Figur 2 zunächst von einem Dielektrikum wie Al₂O₃ gebildet wird. Durch die strukturierte Haltefläche 13 wird die Unterseite des Substrates 12 bereichsweise von einem dielektrischen Material gestützt, während sich in anderen Bereichen Hohlräume 27 bilden, die von dem Substrat 12 und in dem Halteelement 11 auf seiner Oberfläche vorgesehenen Ausnehmungen begrenzt sind.

Die Hohlräume 27 stehen zumindest teilweise mit den Kanälen 25 in Verbindung, so dass das Konvektionsmedium, beispielsweise Helium, in diese vordringen kann. Im Übrigen ist in Figur 3 erkennbar, dass die Klemmspannungszuführungen 16 bis in eine Umgebung der Oberfläche des Halteelementes 11 reichen, und dass dort eine elektrische Gleichspannung anliegt, die eine elektrostatische Fixierung des Substrates 12 auf dem Halteelement 11 bewirkt. Die Struktur der Kanäle 25 und ihre Ausbildung und Durchführung durch den Haltekörper 11 ist beispielsweise wie bei aus dem Stand der Technik bekannten elektrostatischen "Chucks" ausgeführt.

In einem zweiten Ausführungsbeispiel, das ebenfalls mit Hilfe der Figur 3 erläutert wird, ist alternativ zu dem vorstehenden Ausführungsbeispiel das auf der dem Substrat 12 zugewandten Seite des Halteelementes 11 vorgesehene Dielektrikum Al₂O₃ durch ein ferroelektrisches Material oder, bevorzugt, ein piezoelektrisches Material 26 wie eine Blei-Zirkonium-Titanat-Keramik (PZT-Keramik) ersetzt worden, das statt des Al₂O₃ nun als Dielektrikum dient. Der Vorteil ist dabei, dass in einem Piezoelektrikum 26 oder einem alternativ einsetzbaren Ferroelektrikum ohnehin bereits vorhandene permanente Dipole durch das über die Klemmspannungszuführung 16 angelegte elektrische Feld bzw. die darüber angelegte elektrische Gleichspannung ausgerichtet, und dieses somit polarisiert wird, so dass die auf das Substrat 12 ausgeübten elektrostatischen Klemmkräfte erheblich größer sind als im Fall eines Dielektrikums wie Al₂O₃.

Die Polarisation unterstützt somit das über die Klemmspannungszuführungen 16 angelegte äußere elektrische Feld und bewirkt eine Verstärkung der Fixierung des Substrates 12 auf dem Halteelement 11, so dass bei einer gleichen elektrischen Haltespannung nun eine wesentlich höhere Haltekraft auf das Substrat 12 ausgeübt werden kann.

Die gesteigerte elektrostatische Haltekraft erlaubt in einer bevorzugten Weiterführung des Ausführungsbeispiels gemäß Figur 3 nun auch, den Druck des Konvektionsmediums Helium zu erhöhen, und somit die Wärmeabfuhr von der Rückseite des Substrates 12 hin zur Substratelektrode 19 deutlich zu verbessern. Insbesondere wird nun anstelle des ansonsten üblichen Druckes des zugeführten Heliums von 10 bis 20 mbar ein Druck von 50 mbar bis 300 mbar, insbesondere von 100 mbar bis 200 mbar eingesetzt, was zu einer um mehrere Größenordnungen bessere Wärmeableitung führt. Der wesentliche Vorteil eines Piezoelektrikums 26 oder Ferroelektrikums auf der dem Substrat 12 zugewandten Seite des Halteelements 11 ist somit in erster Linie nicht die gesteigerte Haltekraft an sich, sondern vor allem der dadurch ermöglichte höhere Druck des Konvektionsmediums 30 im Bereich der Hohlräume 27 zwischen dem Halteelement 11 und dem Substrat 12.

Im Übrigen sei noch erwähnt, dass durch die Verwendung von piezoelektrischen oder ferroelektrischen Dielektrika die induzierten elektrostatischen Haltekräfte mit dem Abschalten des äußeren elektrischen Feldes oder dem Ausschalten der angelegten elektrischen Spannungen nicht verschwinden, da vorhandene, zunächst ausgerichtete Dipole dies zumindest weitgehend auch im spannungslosen bzw. feldlosen Zustand bleiben. Daher genügt es im Rahmen dieses Ausführungsbeispiels nun nicht mehr, das äußere Feld oder die von Außen angelegte elektrische Spannung einfach abzuschalten, um das Substrat 12 von dem Halteelement 11 zu lösen. Vielmehr muss nun bei einem Ausladen oder Lösen des Substrates 12 von dem Halteelement 11 ein sogenannter "Depolarisationszyklus" unter Verwendung einer Wechselspannung eingesetzt werden, deren Amplitude beispielsweise langsam von einem Ausgangswert auf Null zurückgefahren wird. Dabei verschwindet die Ausrichtung der Dipolmomente weitgehend, d.h. diese liegen danach in einer chaotischen Richtungsverteilung vor. Dieses, an sich bekannte Verfahren ist üblich beim Entmagnetisieren von Materialien und an dieser Stelle erforderlich, um das Substrat 12 ohne größere Kräfte auch wieder von dem Halteelement 11 trennen zu können. Weiter sei an dieser Stelle noch betont, dass durch die Verwendung eines Piezoelektrikums 26 als dielektrisches Material und den erläuterten Depolarisationszyklus über den piezoelektrischen Effekt eine vorteilhafte Schwingungsbewegung (Dickenschwingung) in das Piezoelektrikum 26 induziert wird, was zu einem weiter verbesserten Loslassen des Substrates 12 von dem Halteelement 11 und einem vereinfachten Überwinden vorhandener Adhäsionskräfte zwischen benachbarten Oberflächen führt. Insbesondere verhalten sich mit positiver oder negativer Polarität beaufschlagte Zonen, wie in Figur 3 skizziert, jeweils gegensätzlich, d.h. sie kontrahieren oder expandieren, was das Trennen der Oberflächen wesentlich erleichtert. Zusammenfassend wird durch die Verwendung eines Piezoelektrikums 26 das sogenannte "Declamping" wesentlich erleichtert, was bei üblichen elektrostatischen "Chucks" immer wieder zum Bruch "angeklebter" Wafer beim Ausladen führt.

Die Figur 4 erläutert ein weiteres Ausführungsbeispiel, wobei nun anstelle eines gasförmigen Konvektionsmediums 30 wie Helium eine Flüssigkeit als Konvektionsmedium 30 oder allgemeiner als Wärmetransportmedium 30 zwischen Substrat 12 und Halteelement 11 und/oder zwischen Halteelement 11 und Substratelektrode 19 dient. Dabei nutzt man aus, dass Flüssigkeiten Wärme wesentlich besser leiten als Gase und selbst Helium signifikant überlegen sind. Andererseits scheiden sehr viele Flüssigkeiten zur Kühlung von Substraten in Plasmaätzanlagen aus, weil sie entweder das Substrat 12 oder die Anlage kontaminieren oder selbst in kleinsten Mengen einen schädlichen Einfluss auf den jeweils durchgeführten Ätzprozess ausüben. Eine Ausnahme bilden die Fluorcarbone, d.h. perfluorierte langkettige Alkane oder ähnliche Verbindungen, wie sie beispielsweise von der Firma 3M unter der Bezeichnung FC77, FC84 oder auch als sogenannte "Performance Fluids" ("PF_{XYZ}") vertrieben werden. Solche Fluorcarbone sind hochrein, da sich darin praktisch keine Stoffe lösen, absolut inert und weisen sehr hohe elektrische Durchschlagfeldstärken auf. Zudem ist das Wärmeleitvermögen von Fluorcarbonen ausgezeichnet und ihre Viskosität niedrig.

Zudem werden zum Hochratenätzen in Plasmaätzanlagen in der Regel fluorbasierte Prozesse eingesetzt, so dass Fluorcarbone selbst dann, wenn sie in die Ätzkammer bzw. Vakuumkammer gelangen, in den durchgeführten Ätzprozess nicht eingreifen und keine nachteiligen Auswirkungen auf den Ätzprozess haben.

Insofern ist das mit Hilfe der Figur 4 erläuterte Ausführungsbeispiel besonders für ein Plasmaätzverfahren nach der Art der DE 42 41 045 C1 geeignet, um eine Wärmeabfuhr oder, falls gewünscht, auch eine Zufuhr von Wärme zu oder von der Rückseite des in einer Vakuumkammer gehaltenen Substrates 12 zu leisten, das beispielsweise einem Wärmeeintrag von dessen Vorderseite ausgesetzt ist.

Im Einzelnen geht das mit Hilfe der Figur 4 erläuterte Ausführungsbeispiel zunächst von einer Haltevorrichtung 5 gemäß Figur 2, Figur 3 oder auch der aus dem Stand der Technik bekannten Figur 1 aus, wobei nun jedoch an Stelle des gasförmigen Konvektionsmediums 30 Helium ein flüssiges Konvektionsmedium 30, vorzugsweise ein Fluorcarbon, eingesetzt wird.

Konkret wird das für den jeweils im Einzelfall auftretenden Temperaturbereich ausgewählte Fluorcarbon, beispielsweise das Produkt FC77 der Firma 3M, der Substratelektrode 19 an der Stelle zugeführt, an der ansonsten Helium eingelassen wird. Dazu ist in Figur 4 eine Substratelektrode 19 dargestellt, die eine Zuführung 14 gemäß den Figuren 1 oder 2 aufweist, über die der Oberseite der Substratelektrode 19 das flüssige Konvektionsmedium zugeführt wird. Da sich auf der Substratelektrode 19 das Halteelement 11 befindet, bildet sich zwischen der Substratelektrode und dem Halteelement 11 zunächst ein zweiter Zwischenraum 37 aus. Daneben durchdringt das zugeführte flüssige Konvektionsmedium 30 das Halteelement 11, beispielsweise durch die Kanäle 25, und dringt in den Bereich der Hohlräume oder Ausnehmungen 27 vor, die sich zwischen Halteelement 11 und dem Substrat 12 befinden.

Zur Bereitstellung des flüssigen Konvektionsmediums ist gemäß Figur 4 zunächst ein üblicher Massenflussregler 31 vorgesehen, dem das flüssige Konvektionsmedium 30 zugeführt wird, und der mit einer Steuereinheit 36 in Verbindung steht. Die Steuereinheit 36 steuert den Zufluss des flüssigen Konvektionsmediums 30 über eine übliche Regelung und einen Sollwert/Istwert-Vergleich. Befindet sich ein Substrat 12 auf der Substratelektrode 19 bzw. auf dem Halteelement 11, wird der Massenflussregler 31 und ein weiter vorgesehenes, beispielsweise elektrisch steuerbares Drosselventil 33 von der Steuereinheit 36 so weit geöffnet, dass an einem Drucksensor 32, beispielsweise einem üblichen Baratron, ein gewünschter Druck des flüssigen Konvektionsmediums 30 an der Rückseite des Substrates 12, d.h. der dem Halteelement 11 zugewandten Seite des Substrates 12, gemessen oder eingestellt wird. Dieser hydrostatische Druck pflanzt sich unter dem Substrat 12 fort. Da vor dem Öffnen des Massenflussreglers 31 unter dem Substrat 12 Vakumbedingungen herrschen, füllt das flüssige Konvektionsmedium 30 somit den gesamten Raum zwischen Substrat 12 und Halteelement 11 und zwischen Halteelement 11 und Substratelektrode 19 augenblicklich aus.

Das flüssige Konvektionsmedium 30 wird bevorzugt in das Zentrum der Substratelektrode 19 und/oder das Zentrum des Substrates 12 geleitet und von dort bevorzugt über eine Sammelrinne 28 im Randbereich des Substrates 12 wieder gesammelt und über eine Abführung 29 abgeführt. Die Sammelrinne 28 ist, wie in Figur 4 dargestellt, bevorzugt sowohl im Bereich der Substratelektrode 19 in diese eingelassen, als auch in die dem Substrat 12 zugewandten Seite des Halteelementes 11. Insgesamt wird auf diese Weise das über die Zuführung 14 zugeführte flüssige Konvektionsmedium 30 über die Sammelrinne 28 wieder gesammelt und über eine nicht dargestellte Vakuumpumpe abgesaugt. Da, wie ausgeführt, keine Kompatibilitätsprobleme zwischen einem Hochratenätzverfahren nach der Art der DE 42 41 045 C1 und einem Fluorcarbon als flüssigem Konvektionsmedium 30 bestehen, kann hierfür ein gewöhnlicher Bypass zu einem Anlagenpumpstand oder einer ohnehin für die Vakuumkammer vorgesehenen Turbomolekularpumpe eingesetzt werden.

Der Abfluss des flüssigen Konvektionsmediums 30 geschieht bevorzugt über die elektrisch oder auch manuell einstellbare Drossel 33, über die ein geringer Fluss von beispielsweise 0,1 ccm/min bis 1 ccm/min entsprechend dem gewünschten Druck an der Rückseite des Substrates 12 einmal fest eingestellt wird. Insofern genügt es auch, den Massenflussregler 31 im Zuflussbereich auf einen sehr kleinen Maximalfluss auszulegen, was das Problem von Flüssigkeitsübertritten in die Prozesskammer deutlich entschärft.

Insgesamt fließt das flüssige Konvektionsmedium 30 aus einem Vorratstank, der bevorzugt unter Atmosphärendruck steht, über den Massenflussregler 31 in den Raum zwischen dem Substrat 12 und der Substratelektrode 19, wobei die Steuereinheit 36 durch Ansteuern des Massenflussreglers 31 dafür sorgt, dass dort stets ein gewünschter hydrostatischer Druck von beispielsweise 5 bis 20 mbar vorherrscht. Weiter füllt das flüssige Konvektionsmedium 30 möglichst sämtliche Zwischenräume zwischen dem Substrat 12 und der Substratelektrode 19 aus, und wird schließlich über das Drosselventil 33 wieder abgesaugt, an das sich eine optional vorgesehene Flussmesseinrichtung 34 anschließt, über die die abfließende Menge an Konvektionsmedium 30 bestimmbar ist und an die Steuereinheit 36 übermittelt werden kann.

In bevorzugter Ausgestaltung ist schließlich noch eine Verdampfereinrichtung 35, beispielsweise ein elektrischer Verdampfer, vorgesehen, die sich an das Drosselventil 33 bzw. die Flussmesseinrichtung 34 anschließt, und die das flüssige Konvektionsmedium 30 verdampft und in gasförmigem Zustand der sich daran anschließenden Vakuumpumpe zuführt.

Die Steuereinheit 36 dient bevorzugt auch dazu, eine Fehlfunktion zu erkennen, d.h. in dem Fall, dass das Substrat 12 nicht mehr ausreichend auf dem Halteelement 11 geklemmt ist, was gelegentlich während eines Prozesses vorkommen kann, wird dieser Zustand über die Steuereinheit 36 erkannt, die daraufhin die weitere Zufuhr des flüssigen Konvektionsmediums stoppt. Da in einem solchen Fall der Wärmekontakt zwischen der Substratelektrode 19 und dem Substrat 12 ohnehin verloren ist, muss der durchgeführte Prozess in jedem Fall gestoppt werden, bevor es zu einer thermischen Überhitzung und damit zu einer Zerstörung des als Substrat 12 eingesetzten Siliziumwafers kommt.

Zwar ist ein Fluorcarbon als flüssiges Konvektionsmedium 30, wie bereits ausgeführt, für einen Plasmaätzprozess nach der DE 42 41 045 C1 an sich unschädlich und schadet auch der eingesetzten Vakuumanlage nicht, trotzdem sollte die Menge an Fluorcarbon, die in die Ätzkammer eintritt, stets so gering wie möglich gehalten werden. Dieses Ziel wird dadurch erreicht, dass die Steuereinheit 36 die von dem Massenflussregler 31 detektierte zugeführte Menge an flüssigem Konvektionsmedium 30 ständig mit der von der Flussmesseinrichtung 34 detektierten abfließenden Menge an flüssigem Konvektionsmedium 30 vergleicht. Tritt bei diesem Vergleich eine über gewisse Toleranzen hinausgehende Diskrepanz auf, wird die weitere Zufuhr des flüssigen Konvektionsmediums 30 über die Steuereinheit 36 gestoppt und der Prozess mit einer Fehlermeldung beendet. Daneben ist dann vorgesehen, dass über eine Vakuumabsaugung die Zwischenräume 27, 37 zwischen dem Substrat 12 und der Substratelektrode 19 rasch geleert werden, so dass sich dort bei einem nachfolgenden Ausladen des nicht korrekt geklemmten Substrates 12 kein flüssiges Konvektionsmedium 30 mehr befindet.

Alternativ zu einer Messung der abfließenden Menge an flüssigem Konvektionsmedium 30 ist es ebenso möglich, das Drosselventil 33 einmalig zu kalibrieren, und damit bei einer festen Position des Drosselventils 33 die Menge an über den Massenflussregler 31 zuzuführendem flüssigen Konvektionsmedium 30 zu bestimmen, die erforderlich ist, um den gewünschten hydrostatischen Druck als Funktion der Zeit aufzubauen. Dieser Wert oder diese Wertetabelle in der Form "Druck als Funktion des Flusses" wird daraufhin von der Steuereinheit 36 herangezogen, um bei Abweichungen, insbesondere Überhöhungen, dieses Zuflusswertes sofort ein Leck zu erkennen und den Prozess sowie die weitere Zufuhr des Konvektionsmediums 30 zu unterbrechen. Im Übrigen ist, anders als bei einer Verwendung von gasförmigem Helium als Konvektionsmedium, wo eine Leckage im Elektrodenbereich stets vorhanden ist, da sich Helium über eine elektrostatische Klemmung des Substrates 12 niemals vollständig abdichten lässt, eine Flüssigkeits-Leckage bei einem korrekt geklemmten Substrat 12 äußerst gering, so dass das Drosselventil 33 auf sehr kleine Werte eingestellt werden kann. Zudem muss nun von der Steuereinheit 36 auch kein permanentes Leck als entsprechender Offset oder Sicherheitsvorhalt mehr berücksichtigt werden, wie dies bei der Heliumrückseitenkühlung der Fall ist.

Schließlich ist selbstverständlich, dass die erläuterte Sicherheitseinrichtung, die zum Abschalten des Prozesses führt, in den ersten Sekunden nach dem Beladen des Substrates 12 deaktiviert werden muss, da in dieser Anfangsphase zunächst das flüssige Konvektionsmedium 30 in die vorhandenen Zwischenräume 27, 37 fließen und diese ausfüllen muss, bevor ein Abfluss über die Sammelrinne 28 stattfinden kann. Umgekehrt wird vor dem Ausladen des Substrates 12, das heißt bei abgeschalteter Zufuhr des Konvektionsmediums 30, nur noch ein Abfließen festgestellt, so dass die Vakuumpumpe den Bereich unterhalb des Substrates 12 evakuiert, bevor dieses schließlich trocken von dem Halteelement 11 abgehoben und ausgeladen werden kann.

Die erwähnte, sich durch Verwendung eines flüssigen Konvektionsmediums 30 einstellende gesteigerte elektrische Durchschlagsfestigkeit der Haltevorrichtung 5 resultiert weiter auch daraus, dass das Durchschlagen eines Dielektrikums im Wesentlichen von isolierten, punktuellen Defekten wie sogenannten Pinholes, Hohlräumen, Einschlüssen, Rissen und Gräben mit lokal herabgesetzter Spannungsfestigkeit ausgeht, die lokal auf der Oberfläche des Dielektrikums vorhanden sind und als schwächste Punkte einer ansonsten intakten Oberfläche des elektrostatischen Halteelementes 11 das Versagen des gesamten Bauteils bestimmen. Daher wird, obwohl der größte Teil der Oberfläche des elektrostatischen Halteelementes 11 durchaus höhere elektrische Spannungen oder elektrische Felder tolerieren würde, die tatsächlich applizierbare elektrische Spannung durch einige wenige Punktdefekte limitiert. Da bei dem mit Hilfe der Figur 4 erläuterten Ausführungsbeispiel das gesamte elektrostatische Halteelement 11 bei Betrieb in das flüssige, dielektrische Konvektionsmedium 30 mit hoher elektrischer Durchschlagsfestigkeit und selbstlöschenden Eigenschaften eingebettet ist, werden solche Punktdefekte durch dieses geheilt. Insgesamt führt auch dieser Effekt zu weiter deutlich höheren Klemmkräften und einem sichereren Betrieb der gesamten Haltevorrichtung 5 gegenüber dem Risiko elektrischer Durchschläge.

## Patentansprüche

1. Haltevorrichtung, insbesondere zum Fixieren eines Halbleiterwafers in einer Plasmaätzvorrichtung, mit einem auf einer Substratelektrode (19) angeordneten Halteelement (11), auf dem ein Substrat (12), insbesondere der Halbleiterwafer, elektrostatisch fixierbar ist, wobei
- ein auf der Substratelektrode (19) angeordneter Lastkörper (10) vorgesehen ist, der das Halteelement (11) auf die Substratelektrode (19) drückt,
- der Lastkörper (10) über eine den Lastkörper (10) auf die Substratelektrode (19) pressende Klemmeinrichtung (22, 23, 24) mit einem die Substratelektrode (19) tragenden Grundkörper (17) verbunden ist,
- der Lastkörper (10) und der Grundkörper (17) gegenüber der Substratelektrode (19) elektrisch isoliert sind, und
- der Lastkörper (10) bereichsweise mit der Substratelektrode (19) in Kontakt ist und/oder dass zwischen dem Lastkörper (10) und der Substratelektrode (19) eine Oberflächenunebenheiten ausgleichende und einen gleichmäßigen, möglichst guten Wärmeabfluss gewährleistende Schicht, insbesondere eine Silikonfettschicht oder eine perfluorierte Fettschicht, vorgesehen ist.

2. Haltevorrichtung nach Anspruch 1, **dadurch gekennzeichnet, dass** das Halteelement (11) in Form eines Haltetellers ausgebildet ist, und zumindest auf seiner dem Substrat (12) zugewandten Seite ein Dielektrikum wie Al₂O₃, ein Ferroelektrikum, oder ein Piezoelektrikum (26) wie Blei-Zirkonat-Titanat-Keramik (PZT-Keramik), insbesondere in Form einer entsprechenden Schicht oder Beschichtung, aufweist, das das Halteelement (11) elektrisch gegenüber dem Substrat (12) isoliert.

3. Haltevorrichtung nach Anspruch 2, **dadurch gekennzeichnet, dass** elektrische Bauelemente vorgesehen sind, mit denen in dem Ferroelektrikum oder dem Piezoelektrikum (26) vorhandene permanente Dipole insbesondere zeitweilig derart ausrichtbar sind, das zumindest während der Zeitdauer des ausgerichteten Zustandes eine Fixierung oder Verstärkung der Fixierung des auf dem Halteelement (11) angeordneten Substrates (12) induziert wird, und/oder dass elektrische Bauelemente vorgesehen sind, mit denen in dem Ferroelektrikum oder dem Piezoelektrikum (26) vorhandene permanente Dipole insbesondere zeitweilig derart in ihrer Ausrichtung einstellbar, veränderbar oder in einen im statistischen Mittel zumindest nahezu unausgerichteten Zustand überführbar sind, dass darüber zumindest während dieser Zeitdauer ein Loslösen eines auf dem Halteelement (11) angeordneten Substrates (12) von dem Halteelement (11) induziert oder erleichtert wird.

4. Haltevorrichtung nach mindestens einem der vorangehenden Ansprüche, **dadurch gekennzeichnet, dass** der Lastkörper (10) eine keramische, insbesondere im Wesentlichen ringförmige Platte oder Blende mit einer Öffnung ist, wobei die Öffnung derart dimensioniert und angeordnet ist, dass die dem Halteelement (11) abgewandte Oberfläche des Substrates (12) insbesondere vollständig zugänglich ist.

5. Haltevorrichtung nach mindestens einem der vorangehenden Ansprüche, **dadurch gekennzeichnet, dass** Mittel vorgesehen sind, mit denen die Substratelektrode (19) mit einer insbesondere hochfrequenten Spannung beaufschlagbar ist.

6. Haltevorrichtung nach mindestens einem der vorangehenden Ansprüche, **dadurch gekennzeichnet, dass** das Halteelement (11) mit mindestens einem mit einer Zuführung (14) für ein Konvektionsmedium, insbesondere ein flüssiges Konvektionsmedium (30), verbundenen Kanal (25) oder gasdurchlässigen oder flüssigkeitsdurchlässigen Bereich versehen ist, mit dem der dem Substrat (12) zugewandten Oberfläche des Halteelementes (11) das Konvektionsmedium (30), eine Flüssigkeit (30) wie ein Fluorcarbon oder ein perfluoriertes, langkettiges Alkan, oder ein Gas wie Helium, zuführbar ist.

7. Haltevorrichtung nach Anspruch 6, **dadurch gekennzeichnet, dass** die dem Substrat (12) zugewandte Oberfläche des Halteelementes (11) mit einer mindestens eine Ausnehmung (27) definierenden Strukturierung versehen ist, wobei die Ausnehmungen (27) mit mindestens einem der Kanäle (25) oder gasdurchlässigen oder flüssigkeitsdurchlässigen Bereiche in Verbindung stehen, und darüber mit dem Konvektionsmedium (30) beaufschlagbar sind.

8. Haltevorrichtung nach mindestens einem der vorangehenden Ansprüche, **dadurch gekennzeichnet, dass** die Substratelektrode (19) von dem insbesondere plattenförmigen Grundkörper (17) über einen Isolator (18), insbesondere einen oder mehrere Keramikringe, elektrisch isoliert ist.

9. Haltevorrichtung nach mindestens einem der vorangehenden Ansprüche, **dadurch gekennzeichnet, dass** die Klemmeinrichtung (22, 23, 24) einen insbesondere metallischen Klemmring (22) aufweist, der über mindestens ein insbesondere metallisches Befestigungselement (23) und/oder mindestens ein insbesondere metallisches Verbindungselement (24) elektrisch leitend mit dem Grundkörper (17) verbunden ist.

10. Haltevorrichtung nach mindestens einem der vorangehenden Ansprüche, **dadurch gekennzeichnet, dass** der Grundkörper (17) und/oder die Klemmeinrichtung (22, 23, 24) geerdet ist.

11. Haltevorrichtung nach mindestens einem der vorangehenden Ansprüche, **dadurch gekennzeichnet, dass** Bauteile vorgesehen sind, mit denen zwischen dem Substrat (12) und dem Halteelement (11) und/oder zwischen dem Halteelement (11) und der Substratelektrode (19) eine Klemmspannung anlegbar ist, die die elektrostatische Fixierung des Substrates (12) auf dem Halteelement (11) bewirkt.

12. Haltevorrichtung nach Anspruch 9, **dadurch gekennzeichnet, dass** der Klemmring (22) ein insbesondere oberflächlich eloxierter Aluminiumring ist.

13. Haltevorrichtung nach Anspruch 1, **dadurch gekennzeichnet, dass** eine Einrichtung (30, 31, 32, 33, 34, 35, 36) vorgesehen ist, mit der ein flüssiges oder gasförmiges Konvektionsmedium (30) über mindestens eine Zuführung (14) in einen von dem Halteelement (11) und dem darauf angeordneten Substrat (12) zumindest bereichsweise zwischen beiden gebildeten ersten Zwischenraum (27) zuführbar, und von dort über mindestens eine Abführung (29) wieder abführbar ist.

14. Haltevorrichtung nach Anspruch 13, **dadurch gekennzeichnet, dass** die Einrichtung (31, 32, 33, 34, 35, 36) ein insbesondere elektrisch einstellbares Drosselventil oder einen Massenflussregler (31), einen Drucksensor (32), eine elektronische Steuereinheit (36) und eine Verdampfereinrichtung (35), sowie gegebenenfalls ein insbesondere manuell einstellbares Drosselventil (33) und/oder eine Flussmesseinrichtung (34) aufweist.

15. Haltevorrichtung nach Anspruch 6 oder 7, **dadurch gekennzeichnet, dass** die Substratelektrode (19) eine oder mehrere, insbesondere in ihrem Zentrum oder einer Umgebung ihres Zentrums sie durchquerende Zuführungen (14) aufweist, mit denen das Konvektionsmedium (30) einem mit zumindest einem Teil der Kanäle (25) oder der gas- oder flüssigkeitsdurchlässigen Bereiche in Verbindung stehenden zweiten Zwischenraum (37) zwischen dem Halteelement (11) und der Substratelektrode (19) zuführbar ist, und dass die Substratelektrode (19) eine oder mehrere, insbesondere von dem Zentrum der Substratelektrode möglichst weit entfernte, sie durchquerende Abführungen (29) aufweist, mit denen das Konvektionsmedium (30) aus dem zweiten Zwischenraum (37) abführbar ist.

16. Haltevorrichtung nach Anspruch 15, **dadurch gekennzeichnet, dass** die Abführung (29) im Bereich der dem Halteelement (11) zugewandten Oberfläche der Substratelektrode (19) mit einer insbesondere in die Substratelektrode (19) integrierten Sammelrinne (28) für das Konvektionsmedium (30) in Verbindung steht, und dass die Sammelrinne (28) zumindest mit einem Teil der Kanäle (25) oder der gas- oder flüssigkeitsdurchlässigen Bereiche und/oder dem zweiten Zwischenraum (37) verbunden ist.

17. Haltevorrichtung nach Anspruch 6 oder 7, **dadurch gekennzeichnet, dass** mindestens einer der Kanäle (25) oder der gas- oder flüssigkeitsdurchlässigen Bereiche mindestens einen zwischen dem Substrat (12) und dem Halteelement (11) befindlichen ersten Zwischenraum (27) mit mindestens einem zwischen dem Halteelement (11) und der Substratelektrode (19) befindlichen zweiten Zwischenraum (37) verbindet.

## Claims

1. Retaining device, especially for fixing a semiconductor wafer in a plasma etching device, having a retaining element (11), which is arranged on a substrate electrode (19) and on which a substrate (12), in particular the semiconductor wafer, can be fixed electrostatically, in which case
- a load body (10) is provided, which is arranged on the substrate electrode (19) and presses the retaining element (11) onto the substrate electrode (19),
- the load body (10) is connected to a basic body (17) which carries the substrate electrode (19), by means of a clamping device (22, 23, 24) pressing the load body (10) onto the substrate electrode (19),
- the load body (10) and the basic body (17) are electrically insulated from the substrate electrode (19), and
- the load body (10) is in contact with the substrate electrode (19) in regions, and/or a layer that compensates for surface unevennesses and ensures that heat is dissipated uniformly and as well as possible, in particular a silicone grease layer or a perfluorinated grease layer, is provided between the load body (10) and the substrate electrode (19).

2. Retaining device according to Claim 1,
**characterized in that** the retaining element (11) is embodied in the form of a retaining plate and has, at least on its side facing the substrate (12), a dielectric such as Al₂O₃, a ferroelectric, or a piezoelectric (26) such as lead zirconate titanate ceramic (PZT ceramic), in particular in the form of a corresponding layer or coating, which electrically insulates the retaining element (11) from the substrate (12).

3. Retaining device according to Claim 2, **characterized in that** electrical components are provided by means of which permanent dipoles present in the ferroelectric or the piezoelectric (26) can be oriented in particular temporarily in such a way that a fixing or reinforcement of the fixing of the substrate (12) arranged on the retaining element (11) is induced at least during the time duration of the oriented state, and/or **in that** electrical components are provided by means of which permanent dipoles present in the ferroelectric or the piezoelectric (26) can be set or can be altered in terms of their orientation, or can be transferred into a state which, on average statistically, is at least virtually unoriented, in particular temporarily in such a way that by this means, a release of a substrate (12) arranged on the retaining element (11) from the retaining element (11) is induced or facilitated at least during this time duration.

4. Retaining device according to at least one of the preceding claims, **characterized in that** the load body (10) is a ceramic, in particular essentially annular plate or screen having an opening, the opening being dimensioned and arranged in such a way that that surface of the substrate (12) which is removed from the retaining element (11) is in particular completely accessible.

5. Retaining device according to at least one of the preceding claims, **characterized in that** means are provided which enable an in particular high-frequency voltage to be applied to the substrate electrode (19).

6. Retaining device according to at least one of the preceding claims, **characterized in that** the retaining element (11) is provided with at least one channel (25), or gas-permeable or liquid-permeable region, which is connected to a supply line (14) for a convection medium, in particular a liquid convection medium (30), and by means of which the convection medium (30), a liquid (30) such as a fluorocarbon or a perfluorinated, long-chain alkane, or a gas such as helium can be supplied to that surface of the retaining element (11) which faces the substrate (12).

7. Retaining device according to Claim 6, **characterized in that that** surface of the retaining element (11) which faces the substrate (12) is provided with a patterning which defines at least one cut-out (27), the cut-outs (27) being connected to at least one of the channels (25) or gas-permeable or liquid-permeable regions, and by this means the convection medium (30) being able to be applied to said cut-outs.

8. Retaining device according to at least one of the preceding claims, **characterized in that** the substrate electrode (19) is electrically insulated from the in particular plate-type basic body (17) by means of an insulator (18), in particular one or more ceramic rings.

9. Retaining device according to at least one of the preceding claims, **characterized in that** the clamping device (22, 23, 24) has an in particular metallic clamping ring (22), which is electrically conductively connected to the basic body (17) by means of at least one in particular metallic fastening element (23) and/or at least one in particular metallic connecting element (24).

10. Retaining device according to at least one of the preceding claims, **characterized in that** the basic body (17) and/or the clamping device (22, 23, 24) is earthed.

11. Retaining device according to at least one of the preceding claims, **characterized in that** components are provided by means of which a clamping voltage can be applied between the substrate (12) and the retaining element (11) and/or between the retaining element (11) and the substrate electrode (19), which clamping voltage effects the electrostatic fixing of the substrate (12) on the retaining element (11).

12. Retaining device according to Claim 9,
**characterized in that** the clamping ring (22) is an in particular superficially anodized aluminium ring.

13. Retaining device according to Claim 1, **characterized in that** a device (30, 31, 32, 33, 34, 35, 36) is provided, by means of which a liquid or gaseous convection medium (30) can be supplied by means of at least one supply line (14) into a first interspace (27) formed by the retaining element (11) and the substrate (12) arranged thereon at least in regions between the two, and can be discharged again from there by means of at least one discharge line (29).

14. Retaining device according to Claim 13,
**characterized in that** the device (31, 32, 33, 34, 35, 36) has an in particular electrically settable throttle valve or a mass flow regulator (31), a pressure sensor (32), an electronic control unit (36) and an evaporator device (35), and also, if appropriate, an in particular manually settable throttle valve (33) and/or a flow measuring device (34).

15. Retaining device according to Claim 6 or 7, **characterized in that** the substrate electrode (19) has one or a plurality of supply lines (14) which cross it in particular at its centre or in a vicinity of its centre and by means of which the convection medium (30) can be supplied to a second interspace (37) between the retaining element (11) and the substrate electrode (19), which second interspace is connected to at least one portion of the channels (25) or of the gas- or liquid-permeable regions, and **in that** the substrate electrode (19) has one or a plurality of discharge lines (29) which cross it and in particular are as far away as possible from the centre of the substrate electrode and by means of which the convection medium (30) can be discharged from the second interspace (37).

16. Retaining device according to Claim 15, **characterized in that** the discharge line (29), in the region of that surface of the substrate electrode (19) which faces the retaining element (11), is connected to a collecting groove (28) for the convection medium (30), which collecting groove is integrated in particular into the substrate electrode (19), and **in that** the collecting groove (28) is connected at least to a portion of the channels (25) or of the gas- or liquid-permeable regions and/or the second interspace (37).

17. Retaining device according to Claim 6 or 7, **characterized in that** at least one of the channels (25) or of the gas- or liquid-permeable regions connects at least one first interspace (27) situated between the substrate (12) and the retaining element (11) to at least one second interspace (37) situated between the retaining element (11) and the substrate electrode (19).

## Revendications

1. Dispositif de retenue, notamment pour fixer une plaquette à semiconducteurs dans un dispositif de gravure au plasma, comprenant un élément de retenue (11) disposé sur une électrode de substrat (19) et sur lequel un substrat (12), notamment la plaquette à semiconducteurs, peut être fixé de façon électrostatique, dans lequel
- un corps de charge (10), disposé sur l'électrode de substrat (19), presse l'élément de retenue (11) sur l'électrode de substrat (19),
- le corps de charge (10) est relié à un corps de base (17) portant l'électrode de substrat (19) par un dispositif de serrage (22, 23, 24) pressant le corps de charge (10) sur l'électrode de substrat (19),
- le corps de charge (10) et le corps de base (17) sont électriquement isolés par rapport à l'électrode de substrat (19), et
- le corps de charge (10) est en contact par zone avec l'électrode de substrat (19) et/ ou
- une couche compensant les inégalités de surface et garantissant un écoulement de chaleur uniforme aussi bon que possible, notamment une couche de graisse de silicone ou une couche de graisse perfluorée, est prévue entre le corps de charge (10) et l'électrode de substrat (19).

2. Dispositif de retenue selon la revendication 1,
**caractérisé en ce que**
l'élément de retenue (11) est un disque de retenue, et présente au moins sur son côté tourné vers le substrat (12) un diélectrique tel que Al₂O₃, un ferroélectrique, ou un piézoélectrique (26) tel que la céramique zirconate-titanate de plomb (céramique PZT), notamment sous la forme d'une couche ou d'un revêtement correspondant qui isole électriquement l'élément de retenue (11) par rapport au substrat (12).

3. Dispositif de retenue selon la revendication 2,
**caractérisé en ce que**
des composants électriques permettent d'orienter les dipôles permanents présents dans le ferroélectrique ou le piézoélectrique (26) notamment temporairement pour induire une fixation ou un renforcement de la fixation du substrat (12), disposé sur l'élément de retenue (11) au moins pendant la durée de l'état orienté, et/ou des composants électriques permettent aux dipôles permanents dans le ferroélectrique ou le piézoélectrique (26) d'être notamment temporairement réglés, changés dans leur orientation ou transférés dans un état au moins presque non orienté en moyenne statistique pour en plus induire ou faciliter au moins pendant cette durée un détachement d'un substrat (12) disposé sur l'élément de retenue (11).

4. Dispositif de retenue selon au moins l'une quelconque des revendications précédentes,
**caractérisé en ce que**
le corps de charge (10) est une plaque ou un écran en céramique, notamment sensiblement circulaire avec une ouverture dimensionnée et prévue pour accéder notamment complètement à la surface du substrat (12) détournée de l'élément de retenue (11).

5. Dispositif de retenue selon au moins l'une quelconque des revendications précédentes,
**caractérisé par**
des moyens pour alimenter l'électrode de substrat (19) en tension notamment à haute fréquence.

6. Dispositif de retenue selon au moins l'une quelconque des revendications précédentes,
**caractérisé en ce que**
l'élément de retenue (11) est muni d'au moins un canal (25) relié à une alimentation (14) pour un moyen de convection, notamment un moyen de convection liquide (30) ou une zone perméable au gaz ou au liquide permettant d'amener le moyen de convection (30), un liquide tel qu'un carbone fluoré ou un alcane perfluoré et à chaîne longue, ou un gaz tel que l'hélium, vers la surface de l'élément de retenue (11) tournée vers le substrat (12).

7. Dispositif de retenue selon la revendication 6,
**caractérisé en ce que**
la surface de l'élément de retenue (11) tournée vers le substrat (12), est munie d'une structure définissant au moins un évidement (27), les évidements (27) étant en contact avec au moins l'un des canaux (25) ou les zones perméables au gaz ou au liquide, et pouvant en plus être alimentés avec le moyen de convection (30).

8. Dispositif de retenue selon au moins l'une quelconque des revendications précédentes,
**caractérisé en ce que**
l'électrode de substrat (19) est électriquement isolée notamment du corps de base en forme de plaque (17) par un isolateur (18), notamment une ou plusieurs bagues en céramique.

9. Dispositif de retenue selon au moins l'une quelconque des revendications précédentes,
**caractérisé en ce que**
le dispositif de serrage (22, 23, 24) présente notamment une bague de serrage métallique (22) reliée électriquement au corps de base (17) par au moins un élément de fixation notamment métallique (23) et/ou au moins un raccord notamment métallique (24).

10. Dispositif de retenue selon au moins l'une quelconque des revendications précédentes,
**caractérisé en ce que**
le corps de base (17) et/ou le dispositif de serrage (22, 23, 24) est relié à la terre.

11. Dispositif de retenue selon au moins l'une quelconque des revendications précédentes,
**caractérisé par**
des composants permettant d'appliquer entre le substrat (12) et l'élément de retenue (11) et/ ou entre l'élément de retenue (11) et l'électrode de substrat (19), une contrainte de serrage provoquant la fixation électrostatique du substrat (12) sur l'élément de retenue (11).

12. Dispositif de retenue selon la revendication 9,
**caractérisé en ce que**
la bague de serrage (22) est une bague en aluminium anodisé notamment superficiellement.

13. Dispositif de retenue selon la revendication 1,
**caractérisé par**
une installation (30, 31, 32, 33, 34, 35, 36) permettant d'introduire un moyen de convection liquide ou gazeux (30) au moins par zone entre les deux premiers espaces intermédiaires (27) formés, par au moins une conduite (14) dans l'élément de retenue (11) ou le substrat (12) monté sur celui-ci, et de l'en évacuer à nouveau par au moins une sortie (29).

14. Dispositif de retenue selon la revendication 13,
**caractérisé en ce que**
l'installation (31, 32, 33, 34, 35, 36) présente une soupape d'étranglement réglable notamment électriquement ou un régulateur de flux de masse (31), un capteur de pression (32), une unité de commande électronique (36) et un dispositif évaporateur (35), ainsi qu'éventuellement une soupape d'étranglement réglable notamment manuellement (33) et/ou une installation de mesure de débit (34).

15. Dispositif de retenue selon la revendication 6 ou 7,
**caractérisé en ce que**
l'électrode de substrat (19) présente une ou plusieurs conduites (14) la traversant, notamment dans son centre ou un environnement de son centre (14), pour amener le moyen de convection (30) vers une seconde chambre intermédiaire (37) entre l'élément de retenue (11) et l'électrode de substrat (19) en contact avec au moins une partie des canaux (25) ou des zones perméables au liquide ou au gaz, et l'électrode de substrat (19) présente une ou plusieurs sorties (29) la traversant, notamment éloignées dans la mesure du possible du centre de l'électrode de substrat, pour évacuer le moyen de convection (30) de la seconde chambre intermédiaire (37).

16. Dispositif de retenue selon la revendication 15,
**caractérisé en ce que**
la sortie (29) est en contact pour le moyen de convection (30) avec un tuyau collecteur (28) intégré notamment dans l'électrode de substrat (19) dans la zone de la surface de l'électrode de substrat (19) tournée vers l'élément de retenue (11), et le tuyau collecteur (28) est relié à une partie des canaux (25) ou aux zones perméables au gaz ou au liquide et/ou à la seconde chambre intermédiaire (37).

17. Dispositif de retenue selon la revendication 6 ou 7,
**caractérisé en ce qu'**
au moins l'un des canaux (25) ou l'une des zones perméables au gaz ou au liquide relie au moins une première chambre intermédiaire (27) se trouvant entre le substrat (12) et l'élément de retenue (11) à au moins une seconde chambre intermédiaire (37) se trouvant entre l'élément de retenue (11) et l'électrode de substrat (19).
